# EUROPEAN PATENT APPLICATION

(11) **EP 3 961 303 A1**
(43) Date of publication of application: **02.03.2022**
(21) Application number: 20193101.1
(22) Date of filing: 27.08.2020
(51) Int. Cl.: G03F 7/20, G03F 9/00

(54) **METHOD AND APPARATUS FOR IDENTIFYING CONTAMINATION IN A SEMICONDUCTOR FAB**

(71) Applicant: ASML Netherlands B.V., 5500 AH Veldhoven (NL)
(72) Inventor: COLLIGNON, Tijmen Pieter, 5500 AH Veldhoven (NL); SMAL, Pavel, 5500 AH Veldhoven (NL); TABERY, Cyrus Emil, San Jose, CA 95131 (US)
(74) Representative: ASML Netherlands B.V.

(57) **Abstract**

Methods and associated apparatus for identifying contamination in a semiconductor fab are disclosed. The methods comprise determining contamination map data for a plurality of semiconductor wafers clamped to a wafer table after being processed in the semiconductor fab. Combined contamination map data is determined based, at least in part, on a combination of the contamination map data of the plurality of semiconductor wafers. The combined contamination map data is combined to reference data. The reference data comprises one or more values for the combined contamination map data that are indicative of contamination in one or more tools in the semiconductor fab.

## Description

### FIELD

The invention relates to methods and apparatus for identifying contamination in a semiconductor fab. In exemplary arrangements, the invention may detect the effect of contamination in one or more tools of a semiconductor fab based on measurements obtained by a sensor, such as a level sensor. In some specific exemplary arrangements, the effect of the contamination may be combined with information relating to the fab to influence tool maintenance.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

To achieve good performance, the substrate should be stable and flat during the patterning step. Typically the substrate is held on a substrate support by a clamping force. Conventionally the clamping is achieved by suction. In some lithography tools using extreme ultraviolet (EUV) radiation, the patterning operation is conducted in a vacuum environment. In that case, the clamping force is achieved by electrostatic attraction.

As substrates move through a lithographic apparatus they will have their positions measured with substrate alignment and leveling metrology. This occurs after the substrate is clamped onto the substrate support and before exposure. The intention is to characterize any unique substrate-to-substrate deviations. Deviations can come from several sources; error from substrate placement onto the substrate support, how the prior process in the semiconductor fab has shaped the substrate surface, or if there is contamination on the backside of the substrate. Because the substrate is clamped onto the substrate support, any contamination between the substrate backside and the surface of the substrate holder or any non-uniform support characteristics may affect the substrates surface topography. While in operation, the physical models that control the substrate-to-substrate adjustments of the lithographic apparatus use the alignment and leveling metrology to consistently position each substrate correctly in order to achieve accurate patterning of the substrate.

Defects such as damage to the substrate support during clamping may cause the substrate to be distorted. In particular, it will be understood that the substrate support will degrade over time due to friction between its support surface and the back side of the substrate and/or the effect of chemicals (used in treatment of the substrate during one or more processing steps). This support surface may typically comprise multiple protrusions or burls, largely to mitigate the effect of intervening contaminant particles between substrate and support. One or more of these burls, or other aspects of the substrate support (particularly at the edge), may be affected by such deterioration, resulting in changes in its shape over time which will influence the shape of a substrate clamped thereon. The effects of this deterioration of the substrate support may not be correctable by existing control systems.

A semiconductor fab may contain thousands of different tools used for CMP, diffusion, etch, implant, lithography (scanners, tracks), thin films (CVD), and cleaning. Each individual wafer passing through the fab may undergo hundreds of process steps and every step affects final device yield in some form or another. Contamination related issues are a large factor in yield loss of dies on wafers passing through the fab. However, even if final probe tests reveal that contamination was a cause of yield loss, identifying the exact source of contamination in all the different tools contained in the fab is often very difficult.

### SUMMARY

The inventors have appreciated that it would be desirable to identify contamination or other errors introduced to a lithographic process as a result of contamination or defects in the substrate support. Further, the inventors have appreciated that it would be desirable to determine a location within a semiconductor fab at which such contamination and/or defects have been introduced. Exemplary arrangements disclosed herein may be aimed at solving or mitigating these issues and/or other issues associated with the art.

According to the invention in an aspect, there is provided a method for identifying contamination in a semiconductor fab, the method comprising: determining contamination map data for a plurality of semiconductor wafers clamped to a wafer table after being processed in the semiconductor fab; determining combined contamination map data based, at least in part, on a combination of the contamination map data of the plurality of semiconductor wafers; and comparing the combined contamination map data to reference data, wherein the reference data comprises one or more values for the combined contamination map data that are indicative of contamination in one or more tools in the semiconductor fab.

Optionally, the contamination map data is determined based on data obtained by a levelling sensor.

Optionally, the contamination map data comprises focus spot data.

Optionally, the contamination map data is determined based on applying a spot detection algorithm to wafer height data.

Optionally, the wafer height data comprises continuous surface fitted wafer height data.

Optionally, determining the combined contamination map data comprises determining a union of the contamination map data for the plurality of semiconductor wafers.

Optionally, the reference data comprises data indicative of failure of one or more dies in one or more subsequent semiconductor wafers processed in the semiconductor fab.

Optionally, the reference data comprises a focus error threshold, and wherein combined contamination map data above the focus error threshold is indicative of failure of the one or more dies in the one or more subsequent semiconductor wafers.

Optionally, the reference data comprises a probability of die failure based, at least in part, on the combined contamination map data.

Optionally, the method further comprises determining a die loss map identifying one or more dies of the subsequent semiconductor wafers having a risk of failure based on the combined contamination map data and the focus error threshold.

Optionally, the reference data comprises geometry data relating to one or more tools in the semiconductor fab.

Optionally, the geometry data comprises a position of one or more wafer support features of the one or more tools.

Optionally, the position of the one or more wafer support features comprises a polygon on an area of a surface of the plurality of semiconductor wafers.

Optionally, the method further comprises determining, based on the comparison of the combined contamination map data to the geometry data, one or more tool types in the semiconductor fab that are potential causes of contamination.

Optionally, the method further comprises determining, based on the comparison of the combined contamination map data to the geometry data, one or more tools in the semiconductor fab that are potential causes of contamination.

Optionally, the method further comprises determining, based on the comparison of the combined contamination map data to the geometry data, one or more parts of one or more tools in the semiconductor fab that are potential causes of contamination.

Optionally, the plurality of wafers comprises wafers having, at least partially, a common fab context.

Optionally, the fab context comprises one or more of: a product fabricated on the semiconductor wafers, a layer of device structure fabricated on the semiconductor wafers, a scanner that has fabricated device structure on the semiconductor wafers, a time period during which the semiconductor wafers have been processed, at least partially, in the semiconductor fab and/or a path that the semiconductor wafers have taken through the semiconductor fab.

According to the invention in an aspect, there is provided a computer program comprising instructions which, when executed on at least one processor, cause the at least one processor to control an apparatus to carry out the method according to any disclosed above and/or herein.

According to the invention in an aspect, there is provided a carrier containing the computer program, wherein the carrier is one of an electronic signal, optical signal, radio signal, or non-transitory computer readable storage medium.

According to the invention in an aspect, there is provided an apparatus for identifying contamination in a semiconductor fab, the apparatus comprising a computer processor configured to execute computer program code to undertake the method of: determining contamination map data for a plurality of semiconductor wafers clamped to a wafer table after being processed in the semiconductor fab; determining combined contamination map data based, at least in part, on a combination of the contamination map data of the plurality of semiconductor wafers; and comparing the combined contamination map data to reference data, wherein the reference data comprises one or more values for the combined contamination map data that are indicative of contamination in one or more tools in the semiconductor fab.

The apparatus may comprise other features corresponding to one or more method steps, as set out herein.

According to the invention in an aspect, there is provided a lithographic apparatus comprising the apparatus disclosed above and/or herein.

According to the invention in an aspect, there is provided a litho-cell comprising the lithographic apparatus disclosed above and/or herein.

### Brief description of drawings

Embodiments of the invention will now be described, by way of example only, with reference to the accompanying schematic drawings, in which:
Figure 1 depicts a schematic overview of a lithographic apparatus;
Figure 2 depicts a schematic overview of a lithographic cell;
Figure 3 depicts a schematic representation of holistic lithography, representing a cooperation between three key technologies to optimize semiconductor manufacturing;
Figure 4 shows an exemplary wafer table of a lithographic apparatus or tool, which may form part of a semiconductor fab;
Figures 5a and 5b schematically show the effect of contamination on a semiconductor wafer when passing through a lithographic apparatus; and
Figure 6 shows an exemplary method of identifying contamination in a semiconductor fab.

### Detailed description

Generally, disclosed herein are methods and apparatus for identifying contamination and/or substrate support defects in a semiconductor fab. Exemplary arrangements determine a contamination or defect map, which in some examples comprises a focus spot map. The contamination map may identify areas of the surface of a wafer that exhibit a focus error, i.e. that have a localised height difference compared to other areas of the wafer, which can be an indication of contamination or defect. The contamination map for a plurality of wafers may be combined such that common areas of possible contamination across the plurality of wafers are identified. These common areas may be compared to reference data to determine whether contamination exists in the fab and/or whether one or more wafer supports includes a defect.

Before describing embodiments of the methods and apparatus disclosed herein, there follows a general description of example environments in which one or more of those embodiments may be implemented.

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

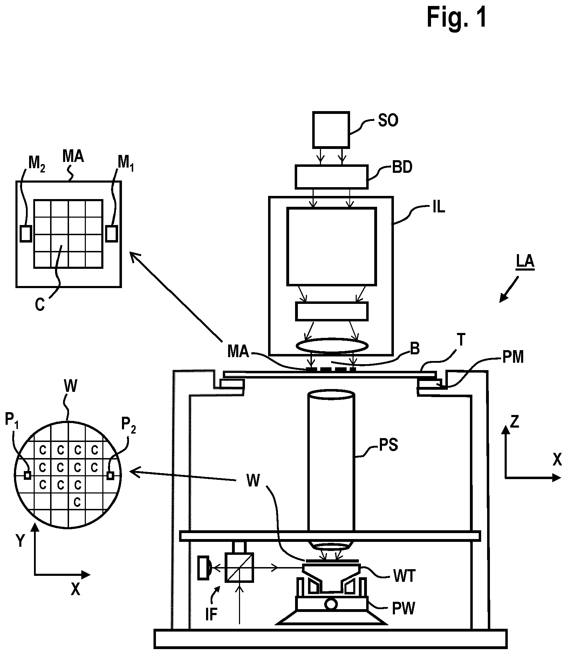

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks P1, P2 are known as scribe-lane alignment marks when these are located between the target portions C.

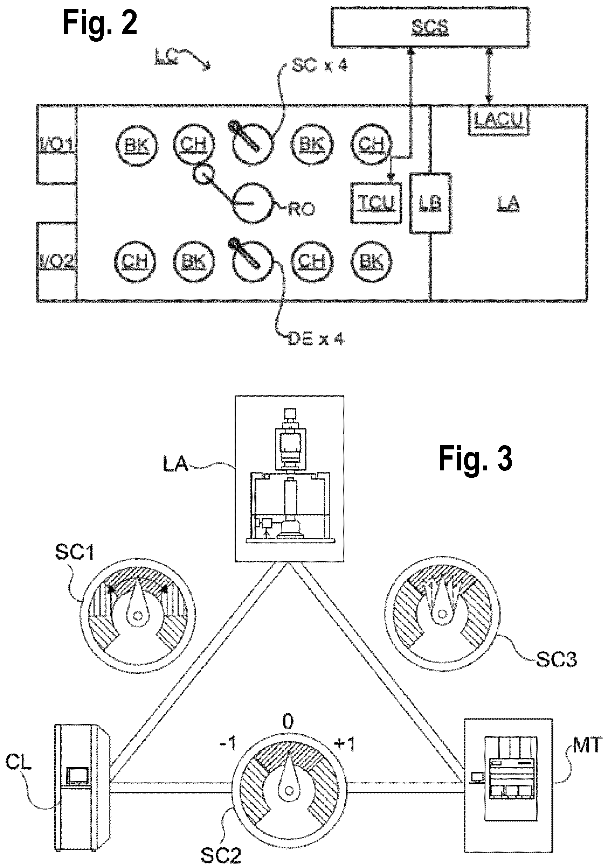

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1628164A, incorporated herein by reference in their entirety. Aforementioned scatterometers may measure gratings using light from soft x-ray, extreme ultraviolet and visible to near-IR wavelength range.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Exemplary arrangements of the methods and apparatus disclosed herein are now described in detail.

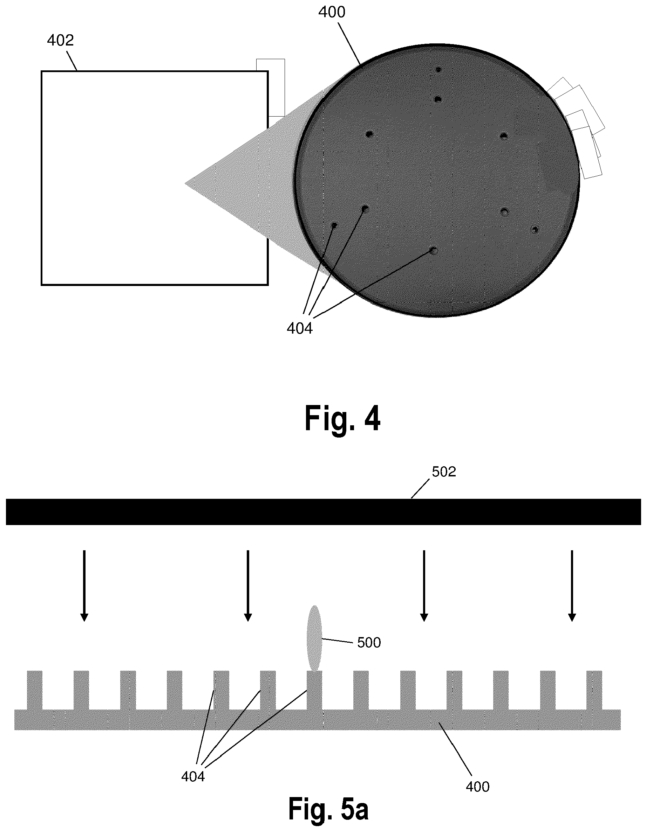

Figure 4 shows an exemplary wafer table (or wafer support) 400 of a lithographic apparatus (or tool) 402, which may form part of a semiconductor fab. The wafer table 400 comprises a plurality of wafer support features 404. The wafer support features 404 comprise a plurality of pins (or burls). As explained below, the plurality of pins 404 support the wafer while it undergoes one or more processing steps within the lithographic apparatus 402. The plurality of wafer support features 404 may be positioned on the wafer table 400 in a specific geometry. The relative geometry of one or more of the wafer support features 404 may form at least part of geometry data for the lithographic apparatus 402. The relative geometry of the wafer support features may be specific to a particular lithographic apparatus and/or a particular type of lithographic apparatus.

As mentioned above, over time, contamination may be deposited within the lithographic apparatus 402 and may come into contact with a backside of a wafer when the wafer is clamped or held against the wafer table 400.

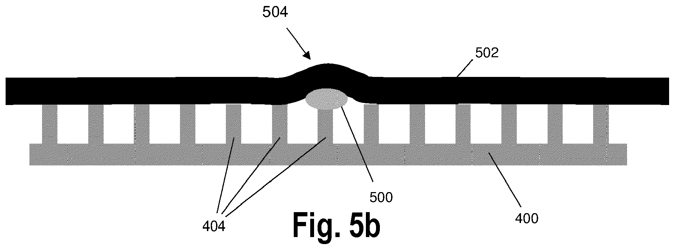

Figures 5a and 5b schematically show the effect of contamination on a semiconductor wafer when passing through a lithographic apparatus.

In Figure 5a, a wafer table 400 comprises a plurality of wafer support features 404. Contamination 500 is shown on an upper surface of one of the wafer support features 404. It is often the case that the contamination 500 may be present on the underside of the wafer 502 alternatively or in addition to contamination 500 on the support features 404. A semiconductor wafer 502 is lowered onto the wafer table 400 and, more specifically, onto the wafer support features 404.

Figure 5b shows the wafer 502 clamped to the wafer table 400 and therefore clamped onto the wafer support features 404. As can be seen, the contamination 500 causes a local height variation 504 on the surface of the wafer 502. The local height variation 504 can cause focus errors and lead to errors in a lithographic process that may affect yield from a wafer. In order to combat the effects of such contamination, lithographic apparatus may be scheduled for maintenance or cleaning periodically. However, the cost of this is significant and it is desirable to undertake such maintenance or cleaning when it is necessary. Further, understanding the extent of contamination and/or wafer table defects within a lithographic apparatus may allow the maintenance or cleaning to be scheduled at a convenient time that minimises downtime of the fab.

Methods and apparatus disclosed herein may use a contamination map to identify regions of a surface of a wafer that are subject to local height variations, such as that shown in Figure 5b. The contamination map may therefore comprise one or more polygons on an image of the surface of the wafer, the polygons identifying areas where contamination may be resulting in local height variations. The contamination map may be determined in a number of different ways and in one exemplary arrangement may be determined based on height data relating to the height of the surface of the wafer, such as data obtained from a levelling sensor.

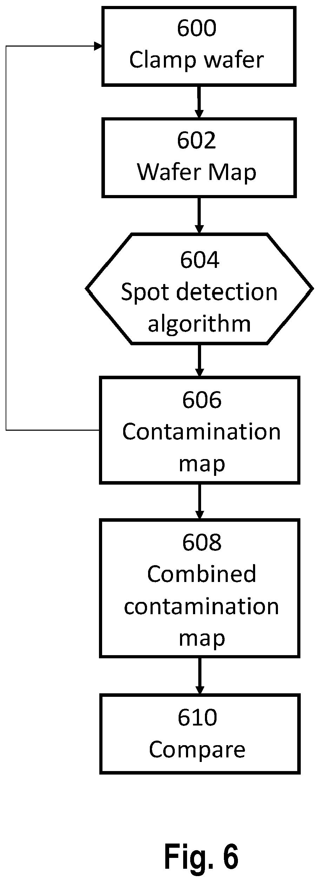

Figure 6 shows an exemplary method of identifying contamination in a semiconductor fab. The method shown in Figure 6 includes an exemplary method of determining a contamination map, in this case to determine a spot map.

A wafer is clamped 600 to a wafer table of a lithographic apparatus. A wafer map is determined 602, which may be determined using wafer height data obtained, for example, from a levelling sensor for a particular wafer. The wafer height data may comprise continuous surface fitted wafer height data for the particular wafer. A spot detection algorithm is run 604 on the wafer map. Spot detection algorithms will be known to the skilled person and are not discussed in detail here. The output is a contamination map, which in this case comprises a list (or other representation) of detected spots 606 on the surface of the wafer, the detected spots representing regions of the wafer surface that include a local height variation. The list of detected spots may include data relating to one or more spots including one or more of an x-y position of the spot on the wafer surface, a height of the spot and a diameter of the spot. In the exemplary method of Figure 6, the determination of a list of detected spots is undertaken a plurality of times to determine contamination map data for a plurality of wafers.

The plurality of contamination maps for the plurality of wafers are combined 608. The combination produces combined contamination map data (which may be combined focus spot data) that identifies common regions of the surfaces of the plurality of wafers that exhibit the effects of possible contamination. That is, in the example shown in Figure 6, the combined contamination map data identifies common areas on the surfaces of the plurality of wafers that contain focus spot errors. In one exemplary arrangement, the combined contamination map data comprises a union of the contamination map data for the plurality of wafers.

The combined contamination map data is compared 610 to reference data for determining whether contamination exists in the semiconductor fab. In one example, the reference data may comprise height threshold data for focus spots in the combined contamination map data. Contamination map data exhibiting a focus spot error greater than the threshold may be determined to be as a result of contamination.

Alternatively or in addition, the reference data may comprise a probability of die failure based, at least in part, on the combined contamination map data. That is, the reference data may comprise a probability of die failure in a region of a wafer surface where focus spots of the combined contamination map data exhibit a certain height. Based on the combined contamination map data and the reference data, a die loss map may therefore be determined. The die loss map may identify one or more dies fabricated on subsequent wafers that have a high probability of failure.

In other exemplary arrangements, the reference data may relate to a context for the plurality of semiconductor wafers - a fab context. As used herein, the term 'fab context' encompasses data relating to one or more a product fabricated on the semiconductor wafers, a layer of device structure fabricated on the semiconductor wafers, a scanner that has fabricated device structure on the semiconductor wafers, a time period during which the semiconductor wafers have been processed, at least partially, in the semiconductor fab and/or a path that the semiconductor wafers have taken through the semiconductor fab. In specific arrangements, the wafer path may comprise a plurality of processes, which may each be represented by Pᵢⱼ, where I is the type of process, and j is the chamber of the fab where the process was undertaken or the tool used.

In exemplary arrangements, the reference data may comprise data relating to a geometry of a tool or type of tool in the fab. The geometry of a tool or type of tool may relate to any feature of the tool, which may produce errors in the contamination map data for a wafer when it is contaminated. For example, the geometry of a tool or type of tool may comprise the position of one or more wafer support features of the tool or type of tool, or of a part of the tool or tool type. These positions may comprise regions or areas on the surface of the wafer, in which if focus spot errors occur they can be attributed to effects relating to the wafer support features, e.g. contamination on those wafer support features.

The combined contamination map data may identify common regions of the surfaces of the plurality of wafers that exhibit focus spot error. If the common regions correspond to the geometry data for a tool or type of tool, e.g. if the location or relative positions of common regions correspond to locations or relative positions of one or more wafer support features, the tool or type of tool may be identified as being the cause of the contamination. In some arrangements, the geometry data may correspond to a specific part of the tool or type of tool and that specific part may be identified as a cause of contamination. The identification of a cause of contamination may comprise one or more of a tool or tool type, a tool part, and a contamination severity. The contamination severity may comprise die loss data, as mentioned above.

In some exemplary methods and apparatus, the plurality of semiconductor wafers for which contamination map data is determined may be selected to have, at least in part, a common fab context. This increases the likelihood that the combined contamination map data will result in common regions of the surfaces of the plurality of wafers that exhibit focus spot error, and thereby increases the accuracy of the determination of a tool, tool type or part of a tool or tool type that may be identified as causing contamination based errors in dies fabricated on the wafers.

Exemplary methods and apparatus may therefore identify die loss data due to contamination for dies fabricated on wafers, and may identify tools, types of tools and/or chambers within the semiconductor fab that are the likely cause of die loss resulting from contamination. This may be used to schedule maintenance and/or cleaning of specific tools within the fab based on their impact on yield.

Further embodiments are disclosed in the list of numbered clauses below:
1. A method for identifying contamination in a semiconductor fab, the method comprising:
   determining contamination map data for a plurality of semiconductor wafers clamped to a wafer table after being processed in the semiconductor fab;
   determining combined contamination map data based, at least in part, on a combination of the contamination map data of the plurality of semiconductor wafers; and
   comparing the combined contamination map data to reference data,
   wherein the reference data comprises one or more values for the combined contamination map data that are indicative of contamination in one or more tools in the semiconductor fab.
2. The method according to clause 1, wherein the contamination map data is determined based on data obtained by a levelling sensor.
3. The method according to clause 1 or 2, wherein the contamination map data comprises focus spot data.
4. The method according to any of clauses 1 to 3, wherein the contamination map data is determined based on applying a spot detection algorithm to wafer height data.
5. The method according to clause 4, wherein the wafer height data comprises continuous surface fitted wafer height data.
6. The method according to any preceding clause, wherein determining the combined contamination map data comprises determining a union of the contamination map data for the plurality of semiconductor wafers.
7. The method according to any preceding clause, wherein the reference data comprises data indicative of failure of one or more dies in one or more subsequent semiconductor wafers processed in the semiconductor fab.
8. The method according to clause 7, wherein the reference data comprises a focus error threshold, and wherein combined contamination map data above the focus error threshold is indicative of failure of the one or more dies in the one or more subsequent semiconductor wafers.
9. The method according to any preceding clause, wherein the reference data comprises a probability of die failure based, at least in part, on the combined contamination map data.
10. The method according to any of clauses 7 to 9, further comprising determining a die loss map identifying one or more dies of the subsequent semiconductor wafers having a risk of failure based on the combined contamination map data and the focus error threshold.
11. The method according to any preceding clause, wherein the reference data comprises geometry data relating to one or more tools in the semiconductor fab.
12. The method according to clause 11, wherein the geometry data comprises a position of one or more wafer support features of the one or more tools.
13. The method according to clause 12, wherein the position of the one or more wafer support features comprises a polygon on an area of a surface of the plurality of semiconductor wafers.
14. The method according to any of clauses 11 to 13, further comprising determining, based on the comparison of the combined contamination map data to the geometry data, one or more tool types in the semiconductor fab that are potential causes of contamination.
15. The method according to any of clauses 11 to 14, further comprising determining, based on the comparison of the combined contamination map data to the geometry data, one or more tools in the semiconductor fab that are potential causes of contamination.
16. The method according to any of clauses 11 to 15 further comprising determining, based on the comparison of the combined contamination map data to the geometry data, one or more parts of one or more tools in the semiconductor fab that are potential causes of contamination.
17. The method according to any preceding clause, wherein the plurality of wafers comprises wafers having, at least partially, a common fab context.
18. The method according to clause 17, wherein the fab context comprises one or more of: a product fabricated on the semiconductor wafers, a layer of device structure fabricated on the semiconductor wafers, a scanner that has fabricated device structure on the semiconductor wafers, a time period during which the semiconductor wafers have been processed, at least partially, in the semiconductor fab and/or a path that the semiconductor wafers have taken through the semiconductor fab.
19. A computer program comprising instructions which, when executed on at least one processor, cause the at least one processor to control an apparatus to carry out the method according to any of clauses 1 to 18.
20. A carrier containing the computer program of clause 19, wherein the carrier is one of an electronic signal, optical signal, radio signal, or non-transitory computer readable storage medium.
21. An apparatus for identifying contamination in a semiconductor fab, the apparatus comprising a computer processor configured to execute computer program code to undertake the method of:
   determining contamination map data for a plurality of semiconductor wafers clamped to a wafer table after being processed in the semiconductor fab;
   determining combined contamination map data based, at least in part, on a combination of the contamination map data of the plurality of semiconductor wafers; and
   comparing the combined contamination map data to reference data,
   wherein the reference data comprises one or more values for the combined contamination map data that are indicative of contamination in one or more tools in the semiconductor fab.
22. A lithographic apparatus comprising the apparatus according to clause 21.
23. A litho-cell comprising the lithographic apparatus according to clause 22.

A computer program may be configured to provide any of the above described methods. The computer program may be provided on a computer readable medium. The computer program may be a computer program product. The product may comprise a non-transitory computer usable storage medium. The computer program product may have computer-readable program code embodied in the medium configured to perform the method. The computer program product may be configured to cause at least one processor to perform some or all of the method.

Various methods and apparatus are described herein with reference to block diagrams or flowchart illustrations of computer-implemented methods, apparatus (systems and/or devices) and/or computer program products. It is understood that a block of the block diagrams and/or flowchart illustrations, and combinations of blocks in the block diagrams and/or flowchart illustrations, can be implemented by computer program instructions that are performed by one or more computer circuits. These computer program instructions may be provided to a processor circuit of a general purpose computer circuit, special purpose computer circuit, and/or other programmable data processing circuit to produce a machine, such that the instructions, which execute via the processor of the computer and/or other programmable data processing apparatus, transform and control transistors, values stored in memory locations, and other hardware components within such circuitry to implement the functions/acts specified in the block diagrams and/or flowchart block or blocks, and thereby create means (functionality) and/or structure for implementing the functions/acts specified in the block diagrams and/or flowchart block(s).

Computer program instructions may also be stored in a computer-readable medium that can direct a computer or other programmable data processing apparatus to function in a particular manner, such that the instructions stored in the computer-readable medium produce an article of manufacture including instructions which implement the functions/acts specified in the block diagrams and/or flowchart block or blocks.

A tangible, non-transitory computer-readable medium may include an electronic, magnetic, optical, electromagnetic, or semiconductor data storage system, apparatus, or device. More specific examples of the computer-readable medium would include the following: a portable computer diskette, a random access memory (RAM) circuit, a read-only memory (ROM) circuit, an erasable programmable read-only memory (EPROM or Flash memory) circuit, a portable compact disc read-only memory (CD-ROM), and a portable digital video disc read-only memory (DVD/Blu-ray).

The computer program instructions may also be loaded onto a computer and/or other programmable data processing apparatus to cause a series of operational steps to be performed on the computer and/or other programmable apparatus to produce a computer-implemented process such that the instructions which execute on the computer or other programmable apparatus provide steps for implementing the functions/acts specified in the block diagrams and/or flowchart block or blocks.

Accordingly, the invention may be embodied in hardware and/or in software (including firmware, resident software, micro-code, etc.) that runs on a processor, which may collectively be referred to as "circuitry," "a module" or variants thereof.

It should also be noted that in some alternate implementations, the functions/acts noted in the blocks may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated.

An apparatus may be configured to undertake any of the methods disclosed herein. In particular, a lithographic apparatus may be configured to undertake any of the methods disclosed herein. In addition, a litho-cell may comprise such a lithographic apparatus.

The skilled person will be able to envisage other embodiments without departing from the scope of the appended claims.

## Claims

1. A method for identifying contamination in a semiconductor fab, the method comprising:
determining contamination map data for a plurality of semiconductor wafers clamped to a wafer table after being processed in the semiconductor fab;
determining combined contamination map data based, at least in part, on a combination of the contamination map data of the plurality of semiconductor wafers; and
comparing the combined contamination map data to reference data,
wherein the reference data comprises one or more values for the combined contamination map data that are indicative of contamination in one or more tools in the semiconductor fab.

2. The method according to claim 1, wherein the contamination map data is determined based on data obtained by a levelling sensor.

3. The method according to claim 1 or 2, wherein the contamination map data comprises focus spot data.

4. The method according to any of claims 1 to 3, wherein the contamination map data is determined based on applying a spot detection algorithm to wafer height data.

5. The method according to claim 4, wherein the wafer height data comprises continuous surface fitted wafer height data.

6. The method according to any preceding claim, wherein determining the combined contamination map data comprises determining a union of the contamination map data for the plurality of semiconductor wafers.

7. The method according to any preceding claim, wherein the reference data comprises data indicative of failure of one or more dies in one or more subsequent semiconductor wafers processed in the semiconductor fab.

8. The method according to claim 7, wherein the reference data comprises a focus error threshold, and wherein combined contamination map data above the focus error threshold is indicative of failure of the one or more dies in the one or more subsequent semiconductor wafers.

9. The method according to any preceding claim, wherein the reference data comprises a probability of die failure based, at least in part, on the combined contamination map data.

10. The method according to any of claims 7 to 9, further comprising determining a die loss map identifying one or more dies of the subsequent semiconductor wafers having a risk of failure based on the combined contamination map data and the focus error threshold.

11. The method according to any preceding claim, wherein the reference data comprises geometry data relating to one or more tools in the semiconductor fab.

12. The method according to claim 11, wherein the geometry data comprises a position of one or more wafer support features of the one or more tools.

13. The method according to claim 12, wherein the position of the one or more wafer support features comprises a polygon on an area of a surface of the plurality of semiconductor wafers.

14. The method according to any of claims 11 to 13, further comprising determining, based on the comparison of the combined contamination map data to the geometry data, one or more tools, parts of one or more tools or tool types in the semiconductor fab that are potential causes of contamination.

15. The method according to any preceding claim, wherein the plurality of wafers comprises wafers having, at least partially, a common fab context, wherein the fab context comprises one or more of: a product fabricated on the semiconductor wafers, a layer of device structure fabricated on the semiconductor wafers, a scanner that has fabricated device structure on the semiconductor wafers, a time period during which the semiconductor wafers have been processed, at least partially, in the semiconductor fab and/or a path that the semiconductor wafers have taken through the semiconductor fab.
